(19) Europäisches Patentamt
European Patent Office
Office européen des brevets

(11) EP 3 352 895 B1

(12) EUROPEAN PATENT SPECIFICATION

(45) Date of publication and mention of the grant of the patent:
**09.09.2020 Bulletin 2020/37**

(21) Application number: **16775574.3**

(22) Date of filing: **22.09.2016**

(51) Int Cl.:
***B01J 13/00*** *(2006.01)* ***B82Y 30/00*** *(2011.01)*
***C01F 17/00*** *(2020.01)*

(86) International application number:
**PCT/EP2016/072538**

(87) International publication number:
**WO 2017/050894 (30.03.2017 Gazette 2017/13)**

# (54) COMPOSTION COMPRISING HYDROPHOBICALLY-MODIFIED CERIUM OXIDE PARTICLES

HYDROPHOBISCH MODIFIZIERTE CERIUMOXIDPARTIKEL UMFASSENDE ZUSAMMENSETZUNG

COMPOSITION COMPRENANT DES PARTICULES D'OXYDE DE CÉRIUM RENDUES HYDROPHOBES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.09.2015 EP 15306477**

(43) Date of publication of application:
**01.08.2018 Bulletin 2018/31**

(73) Proprietor: **Rhodia Operations**
**93300 Aubervilliers (FR)**

(72) Inventors:
- **BUISSETTE, Valérie**
**F-75015 Paris (FR)**
- **D'ALENCON, Lauriane**
**92130 Issy-les-moulineaux (FR)**
- **LE-MERCIER, Thierry**
**93110 Rosny-sous-bois (FR)**
- **TONIOLO, Paolo**
**IT-20020 Cesate (MI) (IT)**
- **CARELLA, Serena**
**IT-20015 Parabiago (MI) (IT)**
- **MIOZZO, Luciano**
**IT-21100 Varese (VA) (IT)**

(74) Representative: **Senninger, Thierry**
**Rhodia Operations**
**Département de la Propriété Industrielle**
**40, rue de la Haie-Coq**
**93306 Aubervilliers Cedex (FR)**

(56) References cited:
**US-A1- 2009 076 207**

- **BAMBANG VERIANSYAH ET AL: "Surface-modified cerium oxide nanoparticles synthesized continuously in supercritical methanol: Study of dispersion stability in ethylene glycol medium", CHEMICAL ENGINEERING JOURNAL, vol. 168, no. 3, 1 April 2011 (2011-04-01) , pages 1346-1351, XP055249304, CH ISSN: 1385-8947, DOI: 10.1016/j.cej.2010.12.055**
- **SHIVA YAZDANI ET AL: "The chemistry concerned with the sonochemical-assisted synthesis of CeO2/poly(amic acid) nanocomposites", TURKISH JOURNAL OF CHEMISTRY, vol. 38, 1 January 2014 (2014-01-01), pages 388-401, XP055249420, Turkey ISSN: 1300-0527, DOI: 10.3906/kim-1306-33**
- **ERIC JOHANSSON SALAZAR-SANDOVAL ET AL: "Aminopolycarboxylic acids as a versatile tool to stabilize ceria nanoparticles - a fundamental model experimentally demonstrated", RSC ADVANCES, vol. 4, no. 18, 1 January 2014 (2014-01-01), page 9048, XP055249699, DOI: 10.1039/c3ra45875j**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Technical Field

The present invention relates to cerium oxide particles having a modified surface, to their manufacture and their uses in polymeric compositions and articles, such as photovoltaic panels.

### Cross-reference to related applications

The present application claims the priority of European patent application EP 15306477.9 filed on 23 September 2015. In case of any incoherency between the present application and the EP application that would affect the clarity of a term or expression, it should be made reference to the present application only.

### Background Art

The UV absorbing properties of cerium oxide are well known. It is also known to prepare polymeric compositions comprising nanosized cerium oxide particles. For instance, EP 1517966 A (RHODIA ELECTRONICS AND CATALYSIS) 30/03/2005 discloses aqueous colloidal dispersions of nanosized cerium oxide particles and their uses to improve the resistance against UV radiation of paints and varnishes, in particular for wood protection applications. EP 1517966 A discloses aqueous dispersions comprising a polymeric material, a colloidal dispersion of cerium oxide particles, at least an organic acid having at least three acidic functions and ammonia or an amine. Specifically, EP 1517966 A discloses dispersions comprising cerium oxide particles having a size in the order of 7-9 nm (determined by transmission electron microscopy, hereinafter "TEM") and comprising citric acid. The presence of citric acid improves the stability of the cerium oxide particles in the aqueous medium, however it does not improve their ability to disperse in organic media.

Dispersions of cerium oxide particles having a particle size of 1 to 5 nm (determined by TEM) in the presence of an amphiphilic acid containing 10 to 50 carbon atoms, preferably 15 to 25 carbon atoms are disclosed in WO 01/10545 A (RHODIA CHIMIE) 15/02/2001.

These dispersions, as well as the powders obtained therefrom, however are characterised by a dark colour which makes them unsuitable for use in applications wherein the colour of the matrix has to be maintained. The presence of the amphiphilic agent has generally the effect of increasing the dark colour of the cerium oxide.

Chem. Eng. J. 2011, 168, 1346-1351 (Veriansyah et al.) discloses cerium oxide nanoparticles prepared in supercritical methanol, the surface of which may be modified by decanoic acid or oleic acid.

Turkish J. Chem. 2014, 38, 388-401 (Yazdani et al.) discloses the preparation of nanocomposites of $CeO_2$ and poly(amic acid).

RSC Adv. 2014, 4, 9048-9055 (Salazar-Sandoval et al.) discloses the stabilization of ceria nanoparticles by aminocarboxylic acids.

US 2009/0076207 discloses a stabilized dispersion of mineral particles by amphiphilic block polymers comprising an hydrophilic block A and an hydrophobic block B.

### Problem to be solved

It has now been found that it is possible to obtain an optimal compromise between the optical properties of nanosized cerium oxide particles and their dispersibility in a polymeric matrix by combining cerium oxide particles with a well-defined particle size and an amphiphilic agent. The particles can be well dispersed in a polymer. Transparent films made of the polymer in which the particles are dispersed can be obtained.

### Description of invention

A first object of the present invention is thus a composition according to the appended claims, which comprises a modified cerium oxide comprising cerium oxide particles having an average particle size from 10 to 90 nm and at least one amphiphilic agent. The at least one amphiphilic agent is generally on the surface of the cerium oxide particles, typically adsorbed on surface of the cerium oxide particles. Preferably the cerium oxide particles are coated with the at least one amphiphilic agent.

The average particle size in the present application is determined either by the X-ray diffraction technique or through the measurement of the BET surface, both techniques being thereafter more precisely defined. Therefore, the average particle size of the modified cerium oxide particles may be from 10 nm to 90 nm as determined by the X-ray diffraction technique. The invention also encompasses modified cerium oxide particles with an average particle size of from 10 nm to 90 nm as determined by the BET method.

The expression "amphiphilic agent" is used in the present specification to refer to a compound comprising at least one polar water-soluble group attached to a water-insoluble hydrocarbon chain. The effect of the amphiphilic agent is to promote a better dispersion of the particles of the cerium oxide in a polymeric matrix.

The at least one amphiphilic agent is selected from the group consisting of the linear or branched, aliphatic or aromatic, acids having from 9 to 50 carbon atoms, optionally carrying functional groups, such as aliphatic carboxylic acids, aliphatic sulphonic acids, aliphatic phosphonic acids, alkylarylsulphonic acids and alkylarylphosphonic acids, whether natural or synthetic, as well as the salts and derivatives of said acids.

The at least one amphiphilic agent can be selected from the group consisting of the linear or branched, aliphatic or aromatic, carboxylic acids having from 9 to 40 carbon atoms, preferably having from 12 to 25 carbon atoms, and their salts and derivatives. The expression "carboxylic acids" includes mono- and polycarboxylic acids.

The amphiphilic agent may be a monocarboxylic acid. Suitable, non-limiting examples of monocarboxylic acids include fatty acids of tall oil, soy oil, tallow oil, linseed oil, oleic acid, linoleic acid, stearic acid, isostearic acid, pelargonic acid, capric acid, lauric acid, myristic acid, 4-hydroxybenzoic acid, 2-ethylhexanoic acid, naphthenic acid, hexoic acid. The amphiphilic agent may be a fatty acid or a salt of a fatty acid. Preferably the amphiphilic agent is an unsaturated acid. More preferably, the amphiphilic agent may be stearic acid or isostearic, their isomers and salts thereof. The amphiphilic agent may preferably be isostearic acid or a salt thereof as it provides good results in terms of dispersion in a polymer and transparency of the film.

The amphiphilic agent may be a polycarboxylic acid, more particularly a dicarboxylic acid. Suitable non-limiting examples of polycarboxylic acids include azelaic acid, sebacic acid, dodecanedioic acid.

The at least one amphiphilic agent may also be selected from the group of carboxylic acids containing ether linkages in the hydrocarbon chain, such as those of formula $R\text{-}(CH_2CO)_n\text{-}COOH$, with R being an alkyl radical having from 1 to 6 carbon atoms, such as for instance

$$H_3CO\text{-}CH_2\text{--}(CH_2CO)\text{-}CH_2\text{-}(CH_2CO)\text{-}CH_2\text{-}COOH.$$

The at least one amphiphilic agent may additionally comprise $CF_2$ units in the chain, e.g. partially fluorinated carboxylic acids of formula $R\text{-}(CF_2)_m\text{-}COOH$, wherein R is as defined above and m is comprised between 10 and 18.

Among suitable acids other than carboxylic acids, mention may be made of dodecylbenzenesulphonic acid, toluenesulphonic acid, toluenephosphonic acid, laurylsulphonic acid, laurylphosphonic acid, palmitylsulphonic acid and palmitylphosphonic acid.

Within the context of the present invention, the at least one amphiphilic agent can also be selected from polyoxyethylenated alkyl ether phosphates of formula (1):

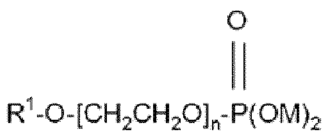

(1)

or polyoxyethylenated dialkyl phosphates of formula (2):

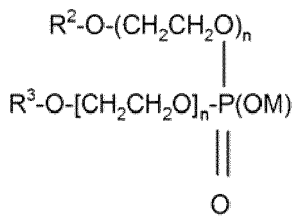

(2)

wherein: $R_1$, $R_2$ and $R_3$, which may be identical or different, represent a linear or branched alkyl radical, in particular containing 2 to 20 carbon atoms; a phenyl radical; an alkylaryl radical, more particularly an alkylphenyl radical, in particular with an alkyl chain containing 8 to 12 carbon atoms; or an arylalkyl radical, more particularly a phenylaryl radical; n represents the number of ethylene oxide units, which can be from 0 to 12; and M represents hydrogen, sodium or potassium.

In particular, $R_1$ can be a hexyl, octyl, decyl, dodecyl, oleyl or nonylphenyl radical.

Notable examples of amphiphilic agents of the phosphate type that can be cited are: polyoxyethylene

($C_8$-$C_{10}$)-alkylether phosphates; polyoxyethylene tridecyl ether phosphate; polyoxyethylene oleodecyl ether phosphate; polyoxyethylene nonylphenyl ether phosphate; polyoxyethylene nonyl ether phosphate.

The at least one amphiphilic agent can be selected from the group consisting of the polyoxyethylenated alkyl ether carboxylates of formula (3):

$$R_4\text{-}(OC_2H_4)_p\text{-}O\text{-}R_5 \qquad (3)$$

wherein $R_4$ is a linear or branched alkyl radical which can in particular contain 4 to 20 carbon atoms; p is an integer from 1 to 20, for example from 2 to16, preferably from 3 to 12; and $R_5$ is a carboxylic acid residue such as $-CH_2COOH$.

In an advantageous embodiment of the invention, the at least one amphiphilic agent is selected from the group consisting of the linear or branched aliphatic carboxylic acids having from 10 to 30 carbon atoms, preferably having from 12 to 25 carbon atoms, and more preferably having from 14 to 20 carbon atoms, and their salts. In a particularly advantageous embodiment the at least one amphiphilic agent is selected from the group consisting of stearic acid, its isomers, in particular isostearic acid, and their salts, e.g. alkaline metal salts. The at least one amphiphilic agent may be sodium or magnesium stearate or isostearic acid.

The modified cerium oxide typically contains at least 0.5 wt% of the at least one amphiphilic agent with respect to the total weight of the modified cerium oxide, preferably at least 1.0 wt%, more preferably at least 2.0 wt%. The amount of the at least one amphiphilic agent generally does not exceed 30.0 wt%, more typically it does not exceed 25.0 wt%, preferably it does not exceed 20.0 wt% with respect to the total weight of the modified cerium oxide. Good results have been obtained with an amount of the at least one amphiphilic agent from 3.0 to 15.0 wt% with respect to the total weight of the modified cerium oxide.

The expression "cerium oxide" is used in the present specification to refer to cerium (IV) oxide, generally to cerium (IV) crystalline oxide. Preferably the cerium oxide is cerium (IV) crystalline oxide.

The modified cerium oxide comprises cerium oxide particles having an average size from 10 to 90 nm.

The average size of the cerium oxide particles can be determined by using an X-ray diffraction technique, hereinafter referred to "XRD". The value of the average particle size measured by XRD corresponds to the size of the coherent range calculated based on the breadth of the two most intense diffraction lines and using the Scherrer model. This model is disclosed in Appl. Cryst. 1978, 11, 102-113, "Scherrer after sixty years: a survey and some new results in the determination of the crystallite size", J. I. Langford et al.

According to this model, an average size t is determined on the basis of formula below:

$$t = \frac{k \cdot \lambda}{\sqrt{H^2 - s^2} \cdot \cos\theta}$$

- k is a dimentionless shape factor (k= 0.9);
- $\lambda$ (lambda) is the wavelength of the radiation (K$\alpha$ line of Cu 1.5406 angstrom);
- H: width at mid-height of the diffraction peak;
- s: instrumental width (correction factor) which depends on the appliance used and on the diffraction angle; s can be determined by analysis of a $LaB_6$ crystal.
- $\theta$: diffraction angle.

The average size of the cerium oxide particles corresponds to the arithmetic mean of the three sizes t1, t2 and t3 which are determined according to the above formula for the three respective diffraction peaks at angles respectively 28.6°; 47.5° and 56.4°. If the peaks at 47.5° and 56.4° do not permit to obtain the sizes t2 and t3 e.g. because they are overlapped or ill defined, the average size may then be determined on size t1 only at angle 28.6°.

The average size of the cerium oxide particles may also be determined by measuring the BET surface area with nitrogen adsorption. The BET surface area is generally determined by nitrogen adsorption in accordance with standard ASTM D 3663-03. The appliance Tristar II 3020 commercialized by Micromeritics is used to determine in an automatic mode the BET surface of the particles following the guidelines defined by Micromeritics. The particles may be heated under vacuum to get rid of any adsorbed water.

The average size is determined on the basis of formula: average size (nm) = 6000 / (BET surface in $m^2/g$ x density in $g/cm^3$). For cerium oxide, the density used is 7200 $kg/cm^3$.

The cerium oxide particles typically have an average size of at most 85 nm, even of at most 80 nm, preferably of at most 70 nm, more preferably of at most 65 nm, even more preferably of at most 50 nm (determined using the BET method).

The cerium oxide particles typically have an average size of at least 12 nm, even of at least 15 nm, typically of

at least 18 nm. The average size of the cerium oxide particles may be of at least 20 nm, even of at least 22 nm, and particularly of at least 25 nm (determined using the BET method).

Advantageously the cerium oxide particles may have an average size from 15 nm to 60 nm, even from 20 nm to 50 nm (determined using the BET method). Cerium oxide particles with an average size of from 25 nm to 45 nm (determined using the BET method) have been found especially useful in certain applications, e.g. the manufacture of polymeric films.

The cerium oxide particles are typically monodisperse, with a standard deviation of at most 30% of the value of the average particle size (determined using the XRD or the BET method). The cerium oxide particles advantageously have an average size of between 10 nm and 90 nm, with a standard deviation of at most 30% of the value of said average particle size (determined using the XRD or the BET method).

The expression "standard deviation" is used herein in its usual mathematical meaning, that is the square root of the variance and it is expressed by the formula:

$$\sigma = \sqrt{\frac{1}{n}\sum_{i=1}^{n}(x_i - \overline{x})^2}$$

wherein n is the number of particles taken into account in the measurement, $x_i$ is the size of a particle i, and $\overline{\chi^2}$ is the average value of the size of the particles ($\overline{\chi^2} = 1/n\Sigma_i x_i$).

The size of the n particles is measured using one or more photograph(s) obtained by transmission electron microscopy (TEM). The photograph(s) is/are generally obtained by depositing a suspension containing the particles on a support and allowing the solvent to evaporate. The principle of the method consists in examining, under the microscope, various regions of a TEM image (around 10) and in measuring the dimensions of at least 250 particles deposited on the support, while considering these particles to be spherical particles. A particle is judged to be identifiable when at least half of its perimeter can be defined. The value $x_i$ corresponds to the diameter of the circle that correctly reproduces the circumference of the particle. The circle can be qualified as the "minimal enclosing circle". The identification of the usable particles can be carried out by using a software for image recognition such as ImageJ, Adobe Photoshop or Analysis. After having measured the size of the particles by the above method, a cumulative particle size distribution of the particles is deduced therefrom, which is regrouped into several particle size categories ranging from 0 to 100 nm, the breadth of each category being 1 nm. The number of particles in each category is the basic data for representing the particle size distribution by number. The average particle size value as determined by this method is the median diameter (commonly defined as dso) obtained from the distribution by number. The median diameter is such that 50% of the particles (by number) counted on the TEM images have a diameter smaller than this value. Use may be made of a transmission electron microscope that gives access to enlargements ranging up to 200 000 or higher.

The standard deviation can be preferably of at most 20%, more particularly at most 15%, and even more particularly at most 10% of the value of the average size of the cerium oxide particles (determined using the XRD or the BET method).

The cerium oxide particles can be prepared following methods known in the art. Advantageously, suitable cerium oxide particles having an average particle size in the range from 10 to 90 nm may be prepared following the method disclosed in WO 2008/043703 A (RHODIA OPERATIONS) 17/04/2008, more particularly the method of example 1 of WO 2008/043703. The method uses a combination of mixture of $Ce^{III}$ and $Ce^{IV}$. The average size can be controlled by changing the $Ce^{IV}$ / $Ce^{III}$ ratio.

The same ranges and definitions of the average particle size, particle size distribution and standard deviation provided for the cerium oxide particles equally apply to the particles of the modified cerium oxide. The presence of the amphiphilic agent has been found to have no or negligible effect on the particle size and particle size distribution of the cerium oxide particles.

In an advantageous embodiment of the invention, the modified cerium oxide comprises cerium oxide particles having an average particle size from 10 to 70 nm (determined using the BET method); and an amount of amphiphilic agent comprised between 3.0 to 15.0 wt% with respect to the total weight of the modified cerium oxide.

In another advantageous embodiment of the invention, the modified cerium oxide comprises cerium oxide particles having an average particle size from 20 to 65 nm, preferably from 20 to 50 nm (determined using the BET method); and isostearic acid or one of its salts in an amount comprised between 4.0 to 15.0 wt% with respect to the total weight of the modified cerium oxide.

The modified cerium oxide is typically in the form of a solid particulate, the particles having the average particle size as defined above.

The modified cerium oxide of the invention may typically be prepared according to any suitable process for the coating of inorganic particles. A suitable method is the one disclosed in Example 1.

According to a first embodiment of the invention the modified cerium oxide may be prepared according to a process wherein the at least one amphiphilic agent is added to the dry particles of the cerium oxide. When the at least one amphiphilic agent is a liquid, the addition can be carried out using the pure amphiphilic agent or a liquid composition comprising the amphiphilic agent and a suitable solvent.

When the at least one amphiphilic agent is a solid it is preferred to dissolve the solid in a suitable solvent to form a liquid composition before carrying out the addition to the cerium oxide particles. The solvent will typically be selected among solvents capable to dissolve the amphiphilic agent and which can be easily removed from the final product and which do not dissolve the cerium oxide particles.

To help dissolve or disperse the amphiphilic agent in the solvent, a base or an acid may be added. For instance, when the amphiphilic agent is in the form of an acid, eg. isostearic acid, a base may be added, as is shown in example 1.

According to another embodiment of the invention, the modified cerium oxide may be prepared according to a process comprising the steps of: providing a composition of cerium oxide particles in a liquid medium; adding at least one amphiphilic agent to said composition; removing the liquid medium; and drying.

The liquid medium is typically selected on the basis of the nature of the cerium oxide particles and of the at least one amphiphilic agent using competences well known to the person skilled in the art.

In an advantageous embodiment of the process, the at least one amphiphilic agent is added to a composition of cerium oxide particles in a liquid medium.

Typically the liquid medium is an organic solvent. The expression "organic solvent" is used to denote one single organic solvent as well as mixtures of more than one organic solvent. The liquid medium may consist of an organic solvent.

Alternatively the liquid medium may comprise an organic solvent and water. When present water typically represents less than 50% by volume of the total volume of the liquid medium. The organic solvent and water may be miscible at the temperature at which the dispersion is used.

As an example of an organic solvent, mention may be made of aliphatic hydrocarbons such as hexane, heptane, octane or nonane; inert cycloaliphatic hydrocarbons such as cyclohexane, cyclopentane or cycloheptane; aromatic hydrocarbons such as benzene, toluene, ethylbenzene, xylenes, or liquid naphthenes.

Chlorinated hydrocarbons, such as chlorobenzene, dichlorobenzene or chlorotoluene, can also be used as organic solvent. Aliphatic and cycloaliphatic ethers or ketones, for instance diisopropyl ether, dibutyl ether, methyl ethyl ketone, methyl isobutyl ketone, diisobutyl ketone or mesityl oxide, can also be used.

Among suitable organic solvent mention may additionally be made of esters, such as those derived from the reaction of acids with alcohols having from 1 to 8 carbon atoms, and in particular palmitates of secondary alcohols such as isopropanol.

In dispersion the particles of modified cerium oxide may form aggregates. Said aggregates of modified cerium oxide particles are typically characterized by an average size of at most 250 nm. The average size of the aggregates may be at most 200 nm, more particularly of at most 170 nm and even more particularly of at most 150 nm.

The aggregates are generally monodisperse. They may have a dispersion index of at most 0.5. This index can be in particular of at most 0.4, more particularly at most 0.3 and even more particularly at most 0.2.

The average size and the dispersion index of the aggregates in the dispersion are determined using a laser diffraction technique using a laser particle sizer (distribution by mass). The term "dispersion index" is intended to refer to the ratio: $\sigma/m = (d_{90}-d_{10})/2d_{50}$ in which $d_{90}$, $d_{10}$ and $d_{50}$ have the common meaning used in statistics;

- $d_{90}$ is the particle size or diameter for which 90% of the particles have a diameter of less than $d_{90}$;
- $d_{10}$ is the particle size or diameter for which 10% of the particles have a diameter of less than $d_{10}$;
- $d_{50}$ is the average size or diameter of the particles.

The dispersions may typically have a modified cerium oxide content which can vary within wide limits and which can, for example, be of at most 40 wt%, in particular at most 30 wt% of oxide with respect to the total weight of the dispersion. The amount of modified cerium oxide in dispersion is generally of at least 0.5 wt%, typically of at least 1.0 wt% with respect to the total weight of the dispersion.

It has been found that the modified cerium oxide of the invention can be incorporated into a polymeric matrix to advantageously provide articles having UV resistance properties and transparency. The modified cerium oxide of the invention may be well dispersed in the polymeric matrix.

Accordingly, the object of the invention is a composition comprising the modified cerium oxide and a polymer.

The composition contains typically at least 0.05 wt %, preferably at least 0.10 wt%, more preferably at least 0.20 wt% of the modified cerium oxide based on the total weight of the composition. The amount the modified cerium oxide typically is at most 10.00 wt %, preferably at most 7.00 wt %, more preferably at most 5.00 wt % based on the total weight of the composition.

Good results were obtained when the modified cerium oxide is present in an amount of 0.10 to 5.00 wt %, based on the total weight of the composition, preferably of 0.20 to 2.00 wt %, based on the total weight of the composition.
The nature of the polymer in the composition is not particularly limited. The polymer may be selected from the group consisting of the alpha-olefin homo- and copolymers, the polycondensation polymers and the halogenated polymers. The polymer may be a thermoplastic polymer.
The expression "alpha-olefin homo- and copolymers" is used herein to refer to polymer comprising recurring units deriving from alpha-olefins. Mention may be made of ethylene homopolymers, propylene homopolymers, ethylene/propylene copolymers, ethylene/1-butene copolymers, ethylene/1-hexene copolymers, ethylene/1-octene copolymers, propylene/1-octene copolymers, ethylene/carboxylic acid vinyl ester copolymers, ethylene/(meth)acrylic acid copolymers, neutralised ethylene/(meth)acrylic acid copolymers.
Among the alpha-olefin copolymers, mention may be made of copolymers comprising recurring units deriving from ethylene and of at least one carboxylic acid vinyl ester. As examples of carboxylic acid vinyl esters, mention may be made of vinyl acetate, vinyl versatate, vinyl propionate, vinyl butyrate or vinyl maleate. Copolymers comprising recurring units of ethylene and vinyl acetate, generally from 5 to 40wt% of recurring units deriving from vinyl acetate and from 60 to 95 wt% of recurring units deriving from ethylene may be preferred.
Alpha-olefin homo-and copolymers may be functionalized for instance by grafting of the non-functionalized polymer with one or more ethylenically unsaturated monomers bearing at least one functional group. Suitable grafting agents are for instance: acrylonitrile, methacrylonitrile, methylvinyl ketone, unsaturated dicarboxylic acids, esters thereof, and anhydrides thereof, e.g. maleic anhydride; acrylic and/or methacrylic acid, and esters thereof.
The expression "polycondensation polymers" is used herein to refer to those polymers which comprise recurring units derived from the condensation reaction of monomers carrying functional groups capable to react with each other, such as polyamides, polyesters, polycarbonates, polyacrylates,
**[0071]** Among suitable polyesters mention may be made of those polyesters comprising recurring units deriving from ethylene glycol and phthalic acids, e.g. terephthalic acid or isophthalic acid.
Among the halogenated polymers mention may be made of the chlorinated and the fluorinated polymers.
Among suitable chlorinated polymers, mention may be made in particular of the polymers comprising recurring units deriving from vinyl chloride, and/or vinylidene chloride.
Among the fluorinated polymers, mention may be made of the polymers comprising recurring units deriving from at least one ethylenically unsaturated fluorinated monomer. Non-limiting examples of suitable ethylenically unsaturated fluorinated monomers are:

- $C_2$-$C_8$ fluorofluoroolefins, such as tetrafluoroethylene, hexafluoropropylene, pentafluoropropylene, and hexafluoroisobutylene;
- $C_2$-$C_8$ hydrogenated fluoroolefins, such as vinyl fluoride, 1,2-difluoroethylene, vinylidene fluoride and trifluoroethylene;
- fluoroalkylethylenes of formula $CH_2$=CH-$R_{f0}$, wherein $R_{f0}$ is a $C_1$-$C_6$ fluoroalkyl or a $C_1$-$C_6$ fluorooxyalkyl having one or more ether groups ;
- chloro-and/or bromo-and/or iodo-$C_2$-$C_6$ fluoroolefins, like chlorotrifluoroethylene;
- fluoroalkylvinylethers of formula $CF_2$=CFO$R_{f1}$ in which $R_{f1}$ is a $C_1$-$C_6$ fluoroalkyl, e.g. -$CF_3$, -$C_2F_5$, -$C_3F_7$.

Notable examples of suitable fluorinated polymers are the polymers comprising recurring units deriving from vinylidene fluoride and the polymers comprising recurring units deriving from ethylene and at least one monomer selected from chlorotrifluoroethylene and tetrafluoroethylene.
In an advantageous embodiment the fluorinated polymer is a polymer comprising recurring units deriving from ethylene and from at least one of chlorotrifluoroethylene and tetrafluoroethylene.
In an advantageous embodiment, the fluorinated polymer is a semi-crystalline polymer comprising recurring units deriving from ethylene and at least one of chlorotrifluoroethylene and tetrafluoroethylene, said polymer having a heat of fusion of at most 35 J/g as determined by Differential Scanning Calorimetry (DSC) at a heating rate of 10°C/min, according to ASTM D 3418.
The heat of fusion is of at most 35 J/g, preferably of at most 30 J/g, more preferably of at most 25 J/g.
The expression "semi-crystalline polymer" is used herein to refer to a polymer having a detectable melting point when determined according to ASTM D 3418. Without lower limit for heat of fusion being critical, it is nevertheless understood that the semi-crystalline polymer will generally possess a heat of fusion of at least 1 J/g, preferably of at least 2 J/g, more preferably of at least 5 J/g.
The fluorinated polymer advantageously comprises:

(a) from 30 to 48%, preferably from 35 to 45 % by moles of ethylene;
(b) from 52 to 70%, preferably from 55 to 65% by moles of chlorotrifluoroethylene, tetrafluoroethylene or a mixture

thereof; and
(c) from 0 to 5%, preferably from 0 to 2.5 % by moles, based on the total amount of monomers (a) and (b), of one or more fluorinated and/or hydrogenated comonomer(s).

Preferably the comonomer is a hydrogenated comonomer selected from the group of the (meth)acrylic monomers. More preferably the hydrogenated comonomer is selected from the group of the hydroxyalkylacrylate comonomers, such as hydroxyethylacrylate, hydroxypropylacrylate and (hydroxy)ethylhexylacrylate, and alkyl acrylate comonomers, such as n-butyl acrylate.
Copolymers of ethylene and chlorotrifluoroethylene and optionally a third monomer, as above detailed, are preferred.
Copolymers of ethylene and chlorotrifluoroethylene suitable in the composition of the invention typically possess a melting temperature not exceeding 210°C, preferably not exceeding 200°C, even not exceeding 198°C, preferably not exceeding 195°C, more preferably not exceeding 193°C, even more preferably not exceeding 190°C. The melting temperature is advantageously at least 120°C, preferably at least 130°C, still preferably at least 140°C, more preferably at least 145°C, even more preferably at least 150°C.
Copolymers of ethylene and chlorotrifluoroethylene which have been found to give particularly good results are those consisting essentially of recurring units derived from:

(a) from 35 to 47% by moles of recurring units deriving from ethylene;
(b) from 53 to 65% by moles of recurring units deriving from chlorotrifluoroethylene.

The melt flow rate of the copolymers of ethylene and chlorotrifluoroethylene suitable for the composition of the invention, measured following the procedure of ASTM 3275-81 at 230°C and 2.16 Kg, ranges generally from 0.01 to 75 g/10 min, preferably from 0.1 to 50 g/10 min, more preferably from 0.5 to 30 g/10 min.
Compositions comprising the modified cerium oxide of the invention and a fluorinated polymer, in particular a copolymer of ethylene and chlorotrifluoroethylene as detailed above, have been found to be suitable for use in the manufacture articles which need protection from UV radiation, such as photovoltaic panels.
Particularly advantageous have been found to be compositions comprising at least 0.5 wt%, preferably at least 1.0 wt% of the modified cerium oxide of the invention and a fluorinated polymer selected from the group of the copolymers of ethylene and at least one of chlorotrifluoroethylene and tetrafluoroethylene.
Compositions comprising at least 0.5 wt%, preferably at least 1.0 wt% of the modified cerium oxide of the invention and a fluorinated polymer selected from the group of the copolymers of ethylene and at least one of chlorotrifluoroethylene and tetrafluoroethylene having a heat of fusion of at most 35 J/g as detailed above have been found to be suitable for the preparation of films for use in photovoltaic applications.
A particularly suitable composition for the preparation of films for use in photovoltaic applications comprises:

- at least 0.5 wt%, preferably at least 1.0 wt% of a modified cerium oxide comprising cerium oxide particles having an average size from 20 to 65 nm and from 4.0 to 15.0 wt% with respect to the total weight of the modified cerium oxide of the at least one amphiphilic agent, preferably isostearic acid, and
- at least one copolymer of ethylene and chlorotrifluoroethylene as detailed above.

Preferably the copolymer of ethylene and chlorotrifluoroethylene comprises from 35 to 47% by moles of recurring units deriving from ethylene and from 53 to 65% by moles of recurring units deriving from chlorotrifluoroethylene, and it has a heat of fusion not exceeding 35 J/g.
The presence of the modified cerium oxide of the invention affords protection from UV.
The composition may be prepared using any conventional technique known in the art. As an example, mixing can be carried out by means of any mixing apparatus known to be useful for preparing polymer compositions, including a roller-type rubber mill, a Banbury mixer, a twinscrew extruder and the like. The modified cerium oxide may be in the form of a dispersion. In that case, the liquid phase of the dispersion is adapted to the conditions of mixing that are used. The modified cerium oxide may be also in the form of a powder (see example 5).
A further object of the invention is an article comprising the composition of the invention.
In an embodiment of the invention the article is in the form of a film or a sheet. The film or sheet may have a thickness of from 15 to 800 μm, preferably from 20 to 600 μm, and more preferably from 25 to 500 μm. The thickness may be determined with a micrometer. The thickness is measured at 25°C and is the arithmetic mean thickness of 20 random measures made on the film.
Techniques for manufacturing films are well known in the art. The composition of the invention will be preferably processed under the form of a film by cast extrusion or hot blown extrusion techniques, optionally with mono- or bi-axial orientation. A technique particularly adapted to the manufacture of films of the composition of the invention involves

extruding the molten composition through a die having elongated shape so as to obtain an extruded tape and casting/calendering said extruded tape so as to obtain a film. The tape can be calendered into a film by passing through appropriate rolls, which can be maintained at appropriate temperatures, and whose speed can be adjusted so as to achieve the required thickness. The thickness of the film is adjusted at the die.

The films of the invention are particularly suitable for being used in photovoltaic modules. The photovoltaic module includes solar cells made of crystalline silicon. Solar cells may be of second-generation solar cells known as "thin-film" solar cells, which are, for example, cells based on amorphous silicon, cadmium telluride (CdTe) or copper indium gallium selinide (CIGS) and homologues thereof, or third-generation cells such as organic photovoltaic (OPV) systems, and dye-sensitized solar cells (DSSC).

Another aspect of the invention is a photovoltaic module comprising the composition of the invention in the form of a film or layer.

The composition in the form of a film or layer may be positioned on the front face of the active elements of the cell, for example in place of the glass of the cell. An active element of the cell is an element that converts light energy into electricity. The film or layer makes it possible to increase the UV protection without impairing the passage of light through the film.

The invention will be now described in more detail with reference to the following examples, the purpose of which is merely illustrative.

Should the disclosure of any patents, patent applications, and publications conflict with the description of the present application to the extent that it may render a term unclear, the present description shall take precedence.

## EXAMPLES

### Example 1 : Preparation of modified cerium oxide having an average particle size of 30 nm

A dispersion of cerium oxide ($CeO_2$) in water was prepared according to the method disclosed in WO 2008/043703 and more particularly in Example 1 of WO 2008/043703. The dispersion had a concentration in $CeO_2$ equivalent of 30 wt%. A volume equivalent to 40 g of dried $CeO_2$ (hereinafter referred to as $CeO_2$-30) was taken (corresponding to 133.3 g of solution).

The particle size was measured using the BET method and found to be 30 nm. The standard deviation, measured using transmission electron microscopy (TEM), was 26% of the average particle size (also determined by TEM).

An aqueous solution of isostearic acid was prepared by mixing 2 g of pure isostearic acid in 100 mL of deionized water. A 1 mol/l soda solution was added dropwise under mixing to reach a pH equal to 10.6 (6.65 g of soda solution).

112.8 g of the aqueous solution of isostearic acid thus obtained were added to the dispersion of cerium oxide by means of a pump at a flow rate of 5 g/min under mixing at room temperature.

After the end of addition, 687 g of water was added in order to respect a concentration of 40 g/L of equivalent dried $CeO_2$. The dispersion was allowed to stir for 2 hours at room temperature. The mixture was centrifuged for 30 min at a speed of 10000 rpm. The white solid obtained after elimination of supernatant was dried in an oven at 50°C for 24h.

41 g of the product were recovered with an organic content of 3.2 wt%.

### Example 2 : Preparation of modified cerium oxide having an average particle size of 10 nm

A dispersion of cerium oxide ($CeO_2$) having a particle size (as measured by BET) of 10 nm was prepared according to the method disclosed in WO 2008/043703 and more particularly in Example 1 of WO 2008/043703 (although a different $Ce^{IV}/Ce^{III}$ ratio is used). The dispersion had a concentration in $CeO_2$ equivalent of 30 wt%. A volume equivalent to 40 g of dried $CeO_2$ (hereinafter referred to as $CeO_2$-10) was taken (corresponding to 133.3 g of solution).

An aqueous solution of isostearic acid was prepared by mixing 5.95 g of pure isostearic acid in 100 mL of deionized water. A 1 mol/l soda solution was added dropwise under mixing to reach a pH equal to 10.6.

112.8 g of the aqueous solution of isostearic acid thus obtained were added to the dispersion of cerium oxide by means of a pump at a flow rate of 5 g/min under mixing at room temperature.

After the end of addition, 687 g of water was added in order to respect a concentration of 40 g/L of equivalent dried $CeO_2$. The dispersion was allowed to stir for 2 hours at room temperature. The mixture was centrifuged for 30 min at a speed of 10000 rpm. The white solid obtained after elimination of supernatant was dried in an oven at 50°C for 24h.

40 g of the product were recovered with an organic content of 11.0 wt%

### Comparative Example 1- Preparation of modified cerium oxide having an average particle size of 3 nm

A modified $CeO_2$ comprising particles with an average particle size of 3 nm and isostearic acid in an amount of 33 wt% was prepared according to the procedure described in Example 2 of WO 01/10545 A.

Cerium oxide particles ($CeO_2$-3) having an average particle size of 3 nm were obtained following the procedure described in step 1 in the same Example of WO 01/10545 A followed by drying at 60°C overnight.

## Example 4 - Colorimetric evaluation of modified $CeO_2$

The colorimetric determination was carried out on the powders of the modified $CeO_2$ of Example 1 and of Comparative Example 1 using an X-Rite Ci51/Ci52 spectrophotometer in the range of wavelengths 400-700 nm (measurement geometries: d/8°, DRS spectral engine, 8mm viewing/14mm illumination; measurement range 0 to 200% reflectance). The L*a*b* values according to the CIE94 method are reported in Table 1, wherein L* represents lightness; a* represents the red/green axis; and b* represents the yellow/blue axis.

**Table 1**

| | L* | a* | b* |
|---|---|---|---|
| $CeO_2$-30 | 84.1 | -2.4 | 9.8 |
| Example 1 (invention) | 81.4 | 1.2 | 12.3 |
| $CeO_2$-3 | 73.7 | -0.8 | 21.8 |
| Comp. Example 1 | 44.4 | 0.6 | 0.6 |

As can be seen in particular from the L* values (which provide an indication of the lightness of the sample, the higher L* the lighter the colour of the sample) when cerium oxide particles with an average particle size of 3 nm are modified with an amphiphilic agent like isostearic acid, their colour becomes dramatically darker (L* value decreasing from 73.7 to 44.4). These particles tend in fact to have a dark brown, black colour which renders them unsuitable for applications in transparent films.

On the other hand, the addition of an amphiphilic agent (isostearic acid) to $CeO_2$ particles of an average particle size of 30 nm does not significantly change the colour of the particles.

## Example 4 : Preparation of a UV-cured film

Films were prepared with non-modified $CeO_2$ particles having an average particle size of 10 nm (hereinafter $CeO_2$-10) and with the modified $CeO_2$ particles prepared in Example 2.

$CeO_2$-10 particles in solid form were obtained by drying the aqueous dispersion used as the starting material in Example 2 in an oven at 50°C overnight.

0.2 g of powder of $CeO_2$ (both non-modified and modified) was mixed to 10 g of HDDA (1,6-hexanediol diacrylate) under magnetic mixing followed by stirring with an Ultraturrax T 25 (Janke & Kunkel) mixing device at a speed of 20 000 rpm during 5 min to provide a suspension of $CeO_2$ particles.

8 g of resin CN820 from Sartomer (composed by HDDA and tripropylene glycol diacrylate) were mixed to 1 g of polymerization initiator (2-methyl-4-methylthio-2-morpholinopropiophenone).

The suspension containing the $CeO_2$ particles was mixed with the resin+initiator solution with Ultraturrax at 20 000 rpm during 5 min.

The mixture was deposited dropwise on a glass substrate with an Elcometer 4340 Automatic Film Applicator to form a fine coating.

The coating was photopolymerized under UV illumination (Omnicure Series 1000/2000) to form a film. Films were dried in an oven at 50°C during 2 days to evaporate some initiator residues. The films separated from the glass substrate after drying were about 140 microns thick.

UV-visible spectroscopy was then performed on films with a spectrometer Perkin-Elmer Lambda 900. Transmittance (in %) as a function of wavelength (in nm) from 190 nm to 800 nm is reported in Figure 1. As it can be seen the film obtained with the modified $CeO_2$ has a much higher transmittance in the visible region than the film obtained with the non-modified $CeO_2$-10, indicating a much better dispersion of the inorganic particles in the polymeric matrix.

## Example 5 - Preparation of films comprising modified $CeO_2$ and a ethylene/chlorotrifluoroethylene copolymer

Raw materials:

- ECTFE: ethylene/chlorotrifluoroethylene copolymer having a melting point of 180°C, a heat of fusion ($\Delta H_{2f}$) of 18 J/g and a melt flow index (MFI) of 3.4 g/10min (measured at 225°C/2.16 kg).
- Modified $CeO_2$ of Example 1.

The polymer, in the form of powder, and the modified $CeO_2$ particles were pre-mixed in a rapid mixer equipped with a three stages paddle mixer so as to obtain a homogeneous powder mixture having required weight ratio between ingredients. The amount of the modified $CeO_2$ was 1.5 wt% with respect to the weight of the composition.

The powder mixture was then processed by extrusion in a double screw conical extruder (Brabender), equipped with 4 temperature zones and a 3 $mm^2$ holes die. Processing set points were as follow:

| T1 (head) | T2 | T3 | T4 |
|---|---|---|---|
| 210°C | 220°C | 230°C | 230°C |

Screw speed was set at 80 rpm, with a torque of 46%, so as to yield a throughput rate of about 3.3 kg/h, and a melt temperature of 231°C. Extruded strands were cooled in a water bath, dried, calibrated and cut in a pelletizer. For manufacturing thin films, pellets were processed in a 19 mm single screw extruder equipped with conventional three zones screw (L/D= 25) without mixing elements. The die used was a flat-die 100 mm wide having a die gap of 500 μm. Upon exit from the die, molten tape was cast on three subsequent chill rolls, whose speed was adapted so as to obtain a film thickness of about 50 μm.

The optical properties of the films were determined using UV-visible spectroscopy using a spectrometer Perkin-Elmer Lambda 900. Transmittance (in %) as a function of wavelength from 190 nm to 800 nm is reported in Figure 2.

A film consisting of the ethylene/chlorotrifluoroethylene ECTFE having the same average thickness of 50 μm is used as a reference.

The film containing the inventive modified $CeO_2$ of Example 1 is effective in blocking the passage of radiation in the 190 nm - 320 nm region of the spectrum with a small impact on the optical properties of the films in the visible region of the spectrum (500-700 nm).

## Claims

1. A composition comprising a modified cerium (IV) oxide and at least one polymer selected from the group consisting of:

   - the alpha-olefin homo- and copolymers ;
   - the halogenated polymers ;
   - the polycondensation polymers selected from the group of polyesters, polycarbonates and polyacrylates ;

   the modified cerium oxide being in the form of cerium oxide particles having an average particle size from 10 nm to 90 nm and at least one amphiphilic agent selected from the group consisting of the linear or branched, aliphatic or aromatic, acids having from 9 to 50 carbon atoms, optionally carrying functional groups, as well as their salts, wherein the modified cerium particles are dispersed in the polymer.

2. The composition according to claims 1 wherein the amphiphilic agent is selected from the group consisting of the linear or branched aliphatic carboxylic acids having from 10 to 40 carbon atoms and their salts.

3. The composition according to any one of the preceding claims wherein the amphiphilic agent is isostearic acid.

4. The composition according to any one of the preceding claims wherein the at least one amphiphilic agent is least 0.5 wt% and at most 30.0 wt% with respect to the total weight of the modified cerium oxide.

5. The composition according to any one of the preceding claims wherein the cerium oxide particles have an average particle size from 15 nm to 60 nm, more particularly from 20 to 50 nm, even more particularly from 25 to 45 nm.

6. The composition according to claim 1 wherein the cerium oxide particles have an average size from 20 to 65 nm, preferably from 20 to 50 nm and the amphiphilic agent is isostearic acid or a salt thereof in an amount comprised between 4.0 to 15.0 wt% with respect to the total weight of the modified cerium oxide.

7. The composition according to any one of the preceding claims wherein the cerium oxide is cerium (IV) crystalline oxide.

8. The composition according to any one of the preceding claims wherein the cerium oxide particles have a standard deviation of at most 30% of the value of the average particle size.

9. The composition according to any one of the preceding claims wherein the polymer is a thermoplastic polymer.

10. The composition according to any one of the preceding claims wherein the polymer is a fluorinated polymer selected from the group consisting of the polymers comprising recurring units deriving from vinylidene fluoride and the polymers comprising recurring units deriving from ethylene and at least one monomer selected from chlorotrifluoroethylene and tetrafluoroethylene.

11. The composition according to any one of the preceding claims wherein the modified cerium oxide is at least 0.5 wt% and at most 10.0 wt% with respect to the total weight of the composition.

12. The composition according to any one of the preceding claims in the form of a film.

13. The composition according to claim 12 wherein the thickness of the film is from 15 to 800 $\mu$m, preferably from 20 to 600 $\mu$m, and more preferably from 25 to 500 $\mu$m.

14. An article comprising the composition of any one of claims 1 to 13.

15. A photovoltaic panel comprising the article of claim 14 or the composition in the form of a film of claims 12 or 13.

## Patentansprüche

1. Zusammensetzung, die ein modifiziertes Cer(IV)oxid und mindestens ein Polymer umfasst, das aus der Gruppe bestehend aus

   - den Homo- und Copolymeren von alpha-Olefinen;
   - den halogenierten Polymeren;
   - den aus der Gruppe von Polyestern, Polycarbonaten und Polyacrylaten ausgewählten Polykondensationspolymeren ausgewählt ist;

   wobei das modifizierte Ceroxid in Form von Ceroxidteilchen mit einer durchschnittlichen Teilchengröße von 10 nm bis 90 nm und mindestens einem Amphiphil, das aus der Gruppe bestehend aus gegebenenfalls funktionelle Gruppen tragenden linearen oder verzweigten, aliphatischen oder aromatischen Säuren mit 9 bis 50 Kohlenstoffatomen sowie deren Salzen ausgewählt ist, vorliegt,
   wobei die modifizierten Certeilchen in dem Polymer dispergiert sind.

2. Zusammensetzung gemäß Anspruch 1, wobei das Amphiphil aus der Gruppe bestehend aus linearen oder verzweigten aliphatischen Carbonsäuren mit 10 bis 40 Kohlenstoffatomen und deren Salzen ausgewählt ist.

3. Zusammensetzung gemäß einem der vorhergehenden Ansprüche, wobei es sich bei dem Amphiphil um Isostearinsäure handelt.

4. Zusammensetzung gemäß einem der vorhergehenden Ansprüche, wobei das mindestens eine Amphiphil mindestens 0,5 Gew.□% und höchstens 30,0 Gew.□%, bezogen auf das Gesamtgewicht des modifizierten Ceroxids, ausmacht.

5. Zusammensetzung gemäß einem der vorhergehenden Ansprüche, wobei die Ceroxidteilchen eine durchschnittliche Teilchengröße von 15 nm bis 60 nm, spezieller 20 bis 50 nm, noch spezieller 25 bis 45 nm, aufweisen.

6. Zusammensetzung gemäß Anspruch 1, wobei die Ceroxidteilchen eine durchschnittliche Größe von 20 bis 65 nm, vorzugsweise 20 bis 50 nm, aufweisen und es sich bei dem Amphiphil um Isostearinsäure oder ein Salz davon in einer Menge, die zwischen 4,0 bis 15,0 Gew.□%, bezogen auf das Gesamtgewicht des modifizierten Ceroxids,

umfasst, handelt.

**7.** Zusammensetzung gemäß einem der vorhergehenden Ansprüche, wobei es sich bei dem Ceroxid um kristallines Cer(IV)oxid handelt.

**8.** Zusammensetzung gemäß einem der vorhergehenden Ansprüche, wobei der Wert der durchschnittlichen Teilchengröße der Ceroxidteilchen eine Standardabweichung von höchstens 30 % aufweist.

**9.** Zusammensetzung gemäß einem der vorhergehenden Ansprüche, wobei es sich bei dem Polymer um ein thermoplastisches Polymer handelt.

**10.** Zusammensetzung gemäß einem der vorhergehenden Ansprüche, wobei es sich bei dem Polymer um ein fluoriertes Polymer handelt, das aus der Gruppe bestehend aus den Polymeren, die von Vinylidenfluorid abgeleitete Wiederholungseinheiten umfassen, und den Polymeren, die von Ethylen abgeleitete Wiederholungseinheiten und mindestens ein aus Chlortrifluorethylen und Tetrafluorethylen ausgewähltes Monomer umfassen, ausgewählt ist.

**11.** Zusammensetzung gemäß einem der vorhergehenden Ansprüche, wobei das modifizierte Ceroxid mindestens 0,5 Gew.□% und höchstens 10,0 Gew.D%, bezogen auf das Gesamtgewicht der Zusammensetzung, ausmacht.

**12.** Zusammensetzung gemäß einem der vorhergehenden Ansprüche in Form einer Folie.

**13.** Zusammensetzung gemäß Anspruch 12, wobei die Dicke der Folie 15 bis 800 μm, vorzugsweise 20 bis 600 μm und noch weiter bevorzugt 25 bis 500 μm beträgt.

**14.** Gegenstand, der die Zusammensetzung nach einem der Ansprüche 1 bis 13 umfasst.

**15.** Photovoltaikpaneel, umfassend den Gegenstand nach Anspruch 14 oder die Zusammensetzung in Form einer Folie nach den Ansprüchen 12 oder 13.

**Revendications**

**1.** Composition comprenant un oxyde de cérium (IV) modifié et au moins un polymère sélectionné dans le groupe constitué :

- des homopolymères et copolymères d'alpha-oléfines ;
- des polymères halogénés ;
- des polymères de polycondensation sélectionnés dans le groupe constitué de polyesters, de polycarbonates et de polyacrylates ;

l'oxyde de cérium modifié étant sous forme de particules d'oxyde de cérium ayant une taille de particule moyenne de 10 nm à 90 nm et d'au moins un agent amphiphile sélectionné dans le groupe constitué des acides aliphatiques ou aromatiques, linéaires ou ramifiés, comportant de 9 à 50 atomes de carbone, portant optionnellement des groupes fonctionnels, ainsi que leurs sels,
dans laquelle les particules de cérium modifié sont dispersées dans le polymère.

**2.** Composition selon la revendication 1, dans laquelle l'agent amphiphile est sélectionné dans le groupe constitué des acides carboxyliques aliphatiques linéaires ou ramifiés comportant de 10 à 40 atomes de carbone et de leurs sels.

**3.** Composition selon l'une quelconque des revendications précédentes, dans laquelle l'agent amphiphile est l'acide isostéarique.

**4.** Composition selon l'une quelconque des revendications précédentes, dans laquelle ledit au moins un agent amphiphile représente au moins 0,5 % en poids et au maximum 30,0 % en poids relativement au poids total de l'oxyde de cérium modifié.

**5.** Composition selon l'une quelconque des revendications précédentes, dans laquelle les particules d'oxyde de cérium ont une taille de particule moyenne de 15 nm à 60 nm, plus particulièrement de 20 nm à 50 nm, encore plus

particulièrement de 25 nm à 45 nm.

6. Composition selon la revendication 1, dans laquelle les particules d'oxyde de cérium ont une taille moyenne de 20 nm à 65 nm, préférablement de 20 nm à 50 nm, et l'agent amphiphile est l'acide isostéarique ou un sel de celui-ci dans une quantité de 4,0 % en poids à 15,0 % en poids relativement au poids total de l'oxyde de cérium modifié.

7. Composition selon l'une quelconque des revendications précédentes, dans laquelle l'oxyde de cérium est l'oxyde cristallin de cérium (IV).

8. Composition selon l'une quelconque des revendications précédentes, dans laquelle les particules d'oxyde de cérium ont un écart type d'au maximum 30 % de la valeur de la taille de particule moyenne.

9. Composition selon l'une quelconque des revendications précédentes, dans laquelle le polymère est un polymère thermoplastique.

10. Composition selon l'une quelconque des revendications précédentes, dans laquelle le polymère est un polymère fluoré sélectionné dans le groupe constitué des polymères comprenant des unités structurales dérivées de fluorure de vinylidène et des polymères comprenant des unités structurales dérivées d'éthylène et au moins un monomère sélectionné parmi le chlorotrifluoroéthylène et le tétrafluoroéthylène.

11. Composition selon l'une quelconque des revendications précédentes, dans laquelle l'oxyde de cérium modifié représente au moins 0,5 % en poids et au maximum 10,0 % en poids relativement au poids total de la composition.

12. Composition selon l'une quelconque des revendications précédentes sous la forme d'un film.

13. Composition selon la revendication 12, dans laquelle l'épaisseur du film est de 15 μm à 800 μm, préférablement de 20 μm à 600 μm, et plus préférablement de 25 μm à 500 μm.

14. Article comprenant la composition selon l'une quelconque des revendications 1 à 13.

15. Panneau photovoltaïque comprenant l'article selon la revendication 14 ou la composition sous la forme d'un film selon les revendications 12 ou 13.

## FIGURES

### Figure 1

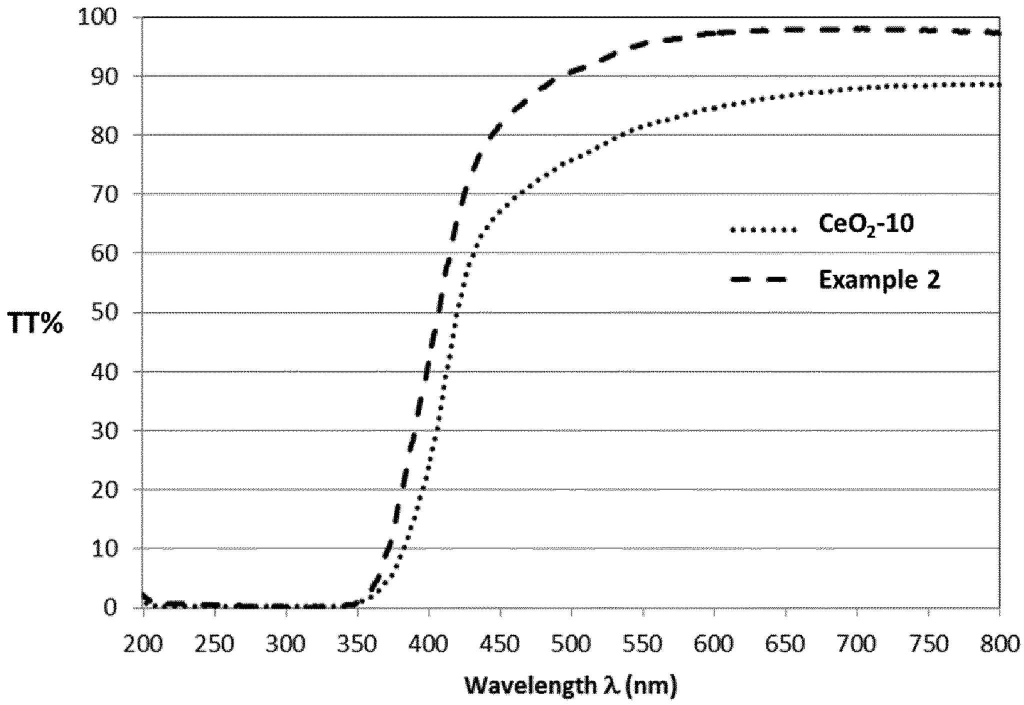


### Figure 2

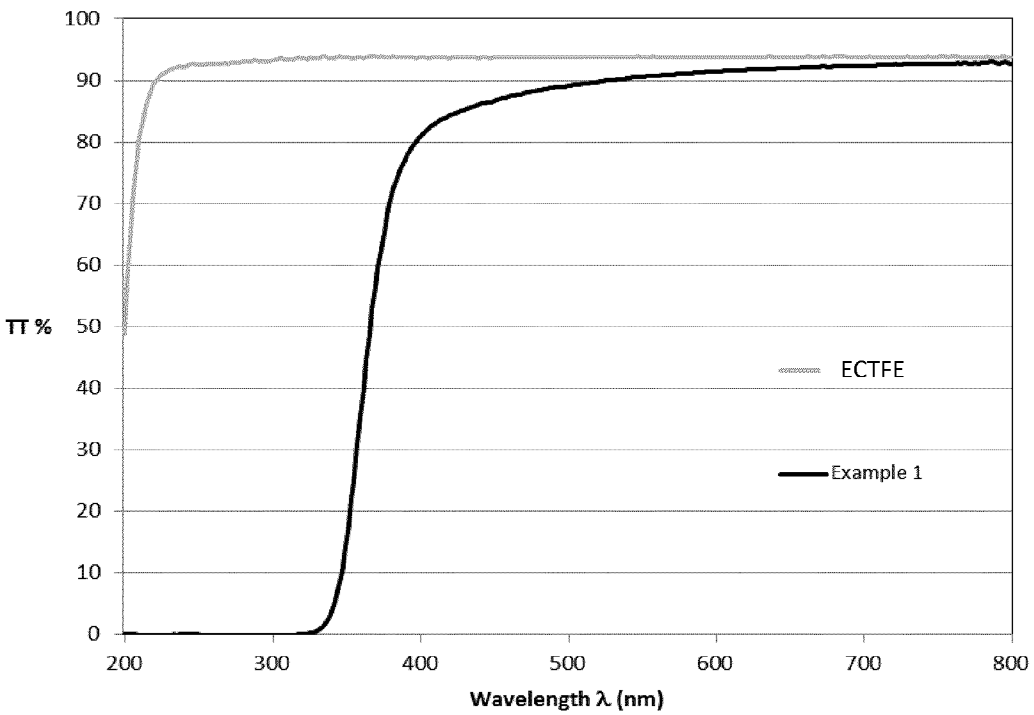

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 15306477
- EP 1517966 A
- WO 0110545 A
- US 20090076207 A
- WO 2008043703 A


### Non-patent literature cited in the description


- **VERIANSYAH.** *Chem. Eng. J.,* 2011, vol. 168, 1346-1351
- **YAZDANI.** *Turkish J. Chem.,* 2014, vol. 38, 388-401
- **SALAZAR-SANDOVAL.** *RSC Adv.,* 2014, vol. 4 (9), 048-9055
- **J. I. LANGFORD.** Scherrer after sixty years: a survey and some new results in the determination of the crystallite size. *Appl. Cryst.,* 1978, vol. 11 (10), 2-113